# EUROPEAN PATENT APPLICATION

(11) **EP 4 521 447 A1**
(43) Date of publication of application: **12.03.2025**
(21) Application number: 24162291.9
(22) Date of filing: 08.03.2024
(51) Int. Cl.: H01L 21/302, H01L 21/02, H01L 29/04

(54) **SILICON SUBSTRATE STRUCTURE**

(30) Priority: 11.09.2023 TW 112134562
(71) Applicant: Taiwan-Asia Semiconductor Corporation, Hsinchu City 30078 (TW)
(72) Inventor: HSIEH, Po-Jen, 30078 Hsinchu City (TW); WANG, Tzu-Wen, 30078 Hsinchu City (TW)
(74) Representative: Michalski Hüttermann & Partner Patentanwälte mbB

(57) **Abstract**

A silicon substrate structure has a substrate, a first groove, a second groove and a third groove. The substrate includes a first surface and a second surface. The first surface is formed on one side of the Si(111) lattice plane, and the second surface is formed on the opposite side of the Si(111) lattice plane. The first groove is disposed along a first direction on the second surface. The second groove is disposed along a second direction on the second surface. The third groove is disposed along a third direction on the second surface. The first direction is defined as the direction from the Si(111) lattice plane to the Si(1-1-1) lattice plane, the second direction is defined as the direction from the Si(-11-1) lattice plane to the Si(1-11) lattice plane, and the third direction is defined as the axial direction of the Si[1-10] lattice orientation.

## Description

### CROSS-REFERENCES TO RELATED APPLICATIONS

This application claims priority to Taiwan Patent Application No. 112134562 filed on September 11, 2023, which is hereby incorporated by reference in its entirety.

### BACKGROUND OF THE INVENTION

### Field of the Invention

The present invention relates to a silicon substrate structure, and in particular to a silicon substrate structure with a plurality of grooves formed along the specific lattice directions to eliminate stress during the stage of epitaxial growth.

### Descriptions of the Related Art

Epitaxial technology plays a critical role in semiconductor manufacturing and optoelectronic fields, primarily involving two materials like silicon carbide and gallium nitride. Epitaxial growth on the gallium nitride layers to produce silicon crystal substrate structures is an essential foundational material for constructing semiconductor components. Due to cost considerations, the mainstream approach in current gallium nitride substrate production still involves the GaN-on-Si technique with epitaxial growth of gallium nitride on silicon substrates, which is a heteroepitaxy technology in the semiconductor industry. Therefore, during epitaxial growth, the expansion due to high temperature causes the gallium nitride layers to become thicker, while silicon substrate expands with increasing temperature. Consequently, the deformation generated beneath silicon substrate also increases with the thickness of gallium nitride epitaxial layer, resulting in an increment of tensile strain within the substrate. When the thickness of the gallium nitride layer exceeds a specific threshold, the compressive stress beneath it is transferred in other directions, and the compression effect on the underlying lattice will be more pronounced. In addition, the thermal expansion effect of the gallium nitride layer will become more obvious as the temperature of epitaxial growth increases, leading to an increase in tensile stress. This further increases the extent of central warping in the silicon substrate, severely affecting the uniformity of the epitaxial process.

However, due to the lattice mismatch and the excessive difference in thermal expansion coefficients between two different materials, strain accumulation is easy to occur in the heterogeneous material. During epitaxial growth, deformation occurs due to temperature increase and uneven stress release occurs when temperature decreases. This affects the quality of the epitaxial film formation or causes crack. The current epitaxial techniques used to improve heterogeneous material include patterned designs on the front side of the epitaxial substrate, corresponding grooves designed on the substrate's front side filled with stress-compensating materials, and the use of buffer layer structures to absorb stress. All these approaches require a more effective epitaxial material to improve substrate warpage at high temperatures and to achieve uniform heating and even stress release after cooling.

In view of the above, the present invention provides a silicon substrate structure to address the problems of poor uniformity during epitaxial growth and the tendency for cracking observed in prior art.

### SUMMARY OF THE INVENTION

The objective of the present invention is to provide a silicon substrate structure that can enable stable epitaxial growth. The present invention designs grooves beneath the substrate structure, which are formed according to three specific lattice directions. When the temperature increases, the deformation of the underlying silicon lattice has space for compression, allowing stable growth of the epitaxial layer on top of the substrate. The spaces of the grooves are capable of compensating for the deformation caused by the warping of the substrate and alleviating the stress that gradually accumulates due to the deformation. On the other hand, when the temperature decreases, the compressed silicon lattice from the high-temperature state gradually consolidates. The cooling gallium nitride layers also provide compressive strain on the silicon substrate. The substrate has a groove design that can reduce the amount of deformation and evenly release strain. Therefore, using the silicon substrate structure of the present invention during the epitaxial process can reduce the occurrence of cracks, enhance uniformity, and further improve the production yield of the epitaxial films.

To achieve the above objective, the present invention discloses a silicon substrate structure, which comprises a substrate, a first groove, a second groove and a third groove. The substrate includes a first surface and a second surface. The first surface is formed on one side of the Si(111) lattice plane, and the second surface is formed on the opposite side of the Si(111) lattice plane. The first groove is disposed along a first direction on the second surface. The second groove is disposed along a second direction on the second surface. The third groove is disposed along a third direction on the second surface. The first direction is defined as a direction from the Si(111) lattice plane to the Si(1-1-1) lattice plane, the second direction is defined as a direction from the SiC -11-1) lattice plane to the Si(1-11) lattice plane, and the third direction is defined as an axial direction of the Si[1-10] lattice orientation.

In an embodiment of the present invention, a first included angle is formed between the first direction and a fourth direction of the Si(111) lattice plane, and a second included angle is formed between the second direction and the fourth direction of the Si(111) lattice plane. The third direction is perpendicular to the fourth direction, and the first included angle is substantially equal to the second included angle.

In an embodiment of the present invention, the first included angle and the second included angle are 35.26 ± 3 degrees.

In an embodiment of the present invention, the first groove comprises a plurality of first groove bodies aligned parallel to the first direction and arranged side by side, the second groove comprises a plurality of second groove bodies aligned parallel to the second direction and arranged side by side, and the third groove comprises a plurality of third groove bodies aligned parallel to the third direction and arranged side by side.

In an embodiment of the present invention, the first groove bodies, the second groove bodies, or the third groove bodies are arranged in a continuous or segmented manner.

In an embodiment of the present invention, the first groove body has a first width, the second groove body has a second width, and the third groove body has a third width. The first width, the second width, and the third width are equal.

In an embodiment of the present invention, each of the first width, the second width, and the third width ranges between 10 micrometers and 5 millimeters.

In an embodiment of the present invention, the substrate and the first groove body define a first height, the substrate and the second groove body define a second height, and the substrate and the third groove body define a third height. The first height, the second height, and the third height are equal.

In an embodiment of the present invention, each of the first height, the second height, and the third height ranges between 500 micrometers and 2000 micrometers.

In an embodiment of the present invention, the substrate has an outer peripheral portion and a cutting edge portion. The outer peripheral portion is connected to the cutting edge portion to define the substrate as a non-circular substrate.

After referring to the diagrams and the subsequently described embodiments, those skilled in the art will readily appreciate other objectives of the present invention, as well as the technical means and embodiments of the invention.

### BRIEF DESCRIPTION OF THE DRAWINGS

FIG. 1 is a schematic view of one embodiment of the combination of the silicon substrate structure and the gallium nitride layer according to the present invention;
FIG. 2 is a top view of one embodiment of the silicon substrate structure according to the present invention;
FIG. 3 is a schematic view of one embodiment of the silicon substrate structure according to the present invention;
FIG. 4 is a schematic view of another embodiment of the silicon substrate structure according to the present invention;
FIG. 5 is a schematic view of another embodiment of the silicon substrate structure according to the present invention;
FIG. 6 is a schematic view of another embodiment of the silicon substrate structure according to the present invention; and
FIG. 7 is a side view of the silicon substrate structure according to the present invention.

### DETAILED DESCRIPTION OF THE PREFERRED EMBODIMENT

Reference will now be made in detail to the present embodiments of the invention, examples of which are illustrated in the accompanying drawings, and are not intended to limit the present invention, applications or particular implementations described in these embodiments. Wherever possible, the same reference numbers are used in the drawings and the description to refer to the same or like parts. It shall be appreciated that, in the following embodiments and the attached drawings, elements unrelated to the present invention are omitted from depiction; and dimensional relationships among individual elements in the attached drawings are provided only for ease of understanding, but not to limit the actual scale.

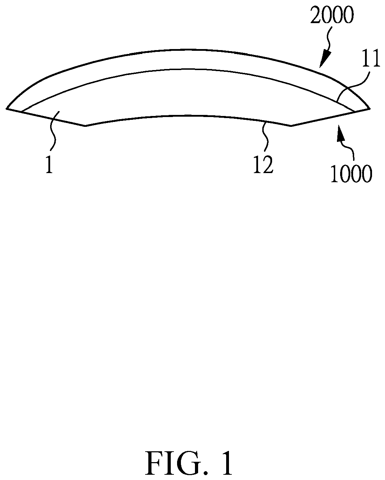

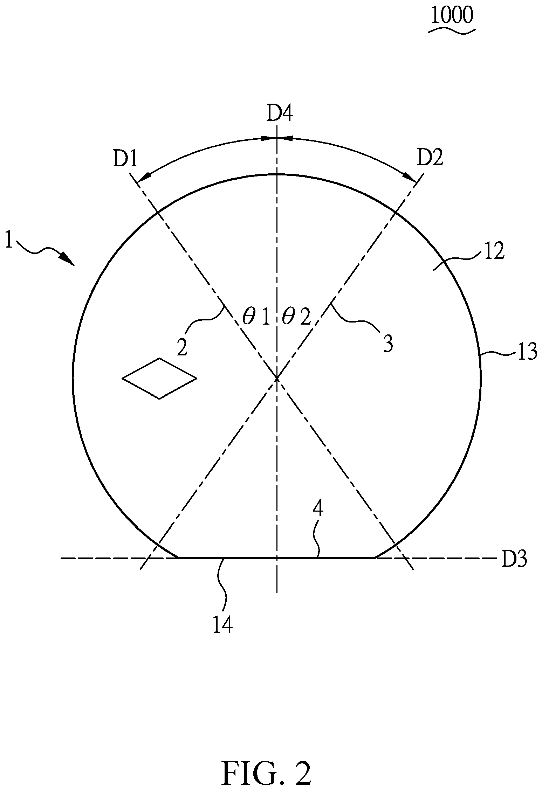

Please refer to FIG. 1 and FIG. 2. FIG. 1 is a schematic view of one embodiment of the combination of the silicon substrate structure 1000 and the gallium nitride layer 2000 according to the present invention. FIG. 2 is a top view of one embodiment of the silicon substrate structure 1000 according to the present invention. The gallium nitride layer 2000 is disposed on the silicon substrate structure 1000 to allow epitaxial growth based on the silicon substrate structure 1000 of the present invention. The silicon substrate structure 1000 comprises a substrate 1, a first groove 2, a second groove 3, and a third groove 4. The first groove 2, the second groove 3, and the third groove 4 are formed on the same surface of the substrate 1.

In detail, the substrate 1 is a silicon substrate oriented along the crystal orientation of <111>. The substrate 1 includes a first surface 11, a second surface 12, an outer peripheral portion 13 and a cutting edge portion 14. The first surface 11 is formed on one side of the Si(111) lattice plane, in other words, the first surface 11 is above the Si(111) lattice plane of the substrate 1. The second surface 12 is formed on the opposite side of the Si(111) lattice plane, in other words, the second surface 12 is beneath the Si(111) lattice plane of the substrate 1. The outer peripheral portion 13 and the cutting edge portion 14 are both outer edge regions of the substrate 1. The outer peripheral portion 13 is connected to the cutting edge portion 14 to define the substrate 1 as a non-circular substrate. It should be noted that the cutting edge portion 14 in this embodiment is located at the lower edge of the substrate 1 as an example. The position of the cutting edge can be adjusted according to actual requirements, which is not limited thereto.

The first groove 2, the second groove 3, and the third groove 4 is further described as below. The first groove 2 is disposed along a first direction D1 on the second surface 12 of the substrate 1. The first groove 2 comprises a plurality of first groove bodies 21 aligned parallel to the first direction D1 and arranged side by side. The second groove 3 is disposed along a second direction D2 on the second surface 12 of the substrate 1. The second groove 3 comprises a plurality of second groove bodies 31 aligned parallel to the second direction D2 and arranged side by side. The third groove 4 is disposed along a third direction D3 on the second surface 12 of the substrate 1. The third groove 4 comprises a plurality of third groove bodies 41 aligned parallel to the third direction D3 and arranged side by side. The first groove 2, the second groove 3, and the third groove 4 are aligned in accordance with the lattice directions. However, the first direction D1 is defined as the direction from the Si(111) lattice plane to the Si(1-1-1) lattice plane, the second direction D2 is defined as the direction from the Si(-11-1) lattice plane to the Si(1-11) lattice plane, and the third direction D3 is defined as the axial direction of the Si[1-10] lattice orientation. At the same time, there is another direction perpendicular to the third direction D3 on the substrate 1, and defined as a fourth direction D4 on the Si(111) lattice plane.

As above, the first direction D1 forms a first included angle θ1 with the fourth direction D4. The second direction D2 forms a second included angle θ2 with the fourth direction D4. The first included angle θ1 is substantially equal to the second included angle θ2. In this embodiment, the first included angle θ1 and the second included angle θ2 are 35.26 ± 3 degrees. In other words, the angle between the first groove body 21 and the second groove body 31 is the sum of the first included angle θ1 and the second included angle θ2.

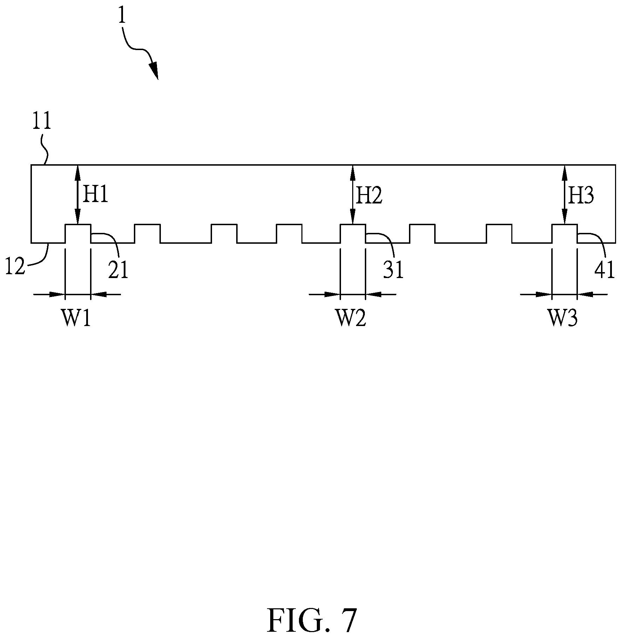

Next, the first groove body 21, the second groove body 31, and the third groove body 41 will be described. As shown in FIG. 7, the first groove body 21 has a first width W1, the second groove body 31 has a second width W2, and the third groove body 41 has a third width W3. In detail, the first groove body 21, the second groove body 31, and the third groove body 41 can be groove bodies with equal widths. The first width W1 is equal to the second width W2, and it is also equal to the third width W3. On the other hand, the first groove body 21, the second groove body 31, and the third groove body 41 can also be groove bodies with unequal widths. Therefore, at least two of the first width W1, the second width W2, and the third width W3 are unequal. In this embodiment, the first width W1, the second width W2, and the third width W3 each range between 10 micrometers (µm) and 5 millimeters (mm).

As above, the first surface 11 of the substrate 1 defines a first height H1 with the first groove body 21. The first surface 11 of the substrate 1 defines a second height H2 with the second groove body 31. The first surface 11 of the substrate 1 defines a third height H3 with the third groove body 41. Specifically, the first groove body 21, the second groove body 31, and the third groove body 41 can be groove bodies with equal heights. The first height H1 is equal to the second height H2, and it is also equal to the third height H3. On the other hand, the first groove body 21, the second groove body 31, and the third groove body 41 can also be groove bodies with unequal heights. Therefore, at least two of the first height H1, the second height H2, and the third height H3 are unequal. In this embodiment, the first height H1, the second height H2, and the third height H3 each range between 500 micrometers and 2000 micrometers. In other words, the first height H1, the second height H2, and the third height H3 represent the distances between the deepest points of the respective groove bodies, namely, the first groove body 21, the second groove body 31, and the third groove body 41, and the first surface 11 of the substrate 1. The widths of each groove body and the distances between each groove body and the surface of the substrate 1 are utilized to release the stress on the substrate 1 caused by temperature variations during epitaxial growth.

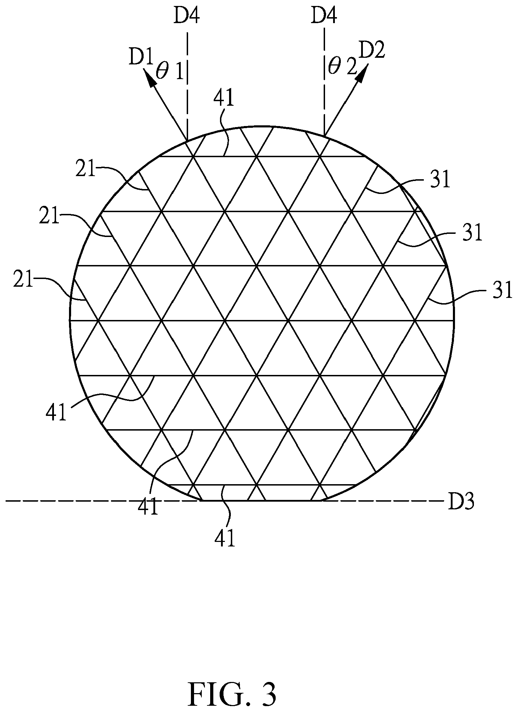

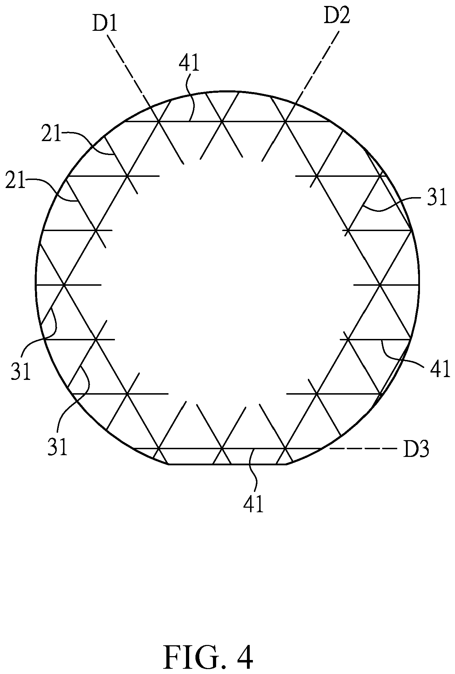

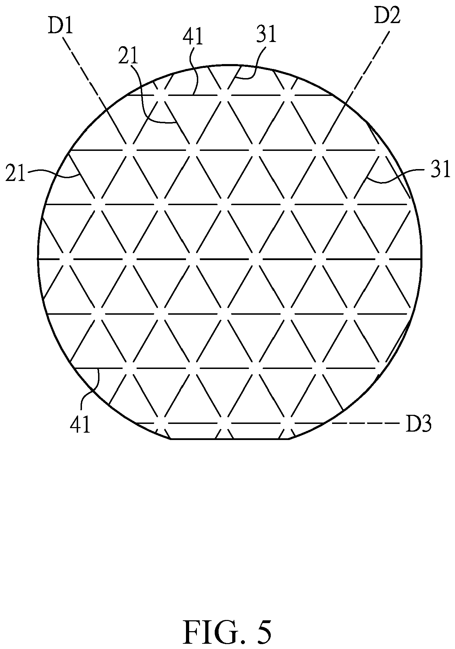

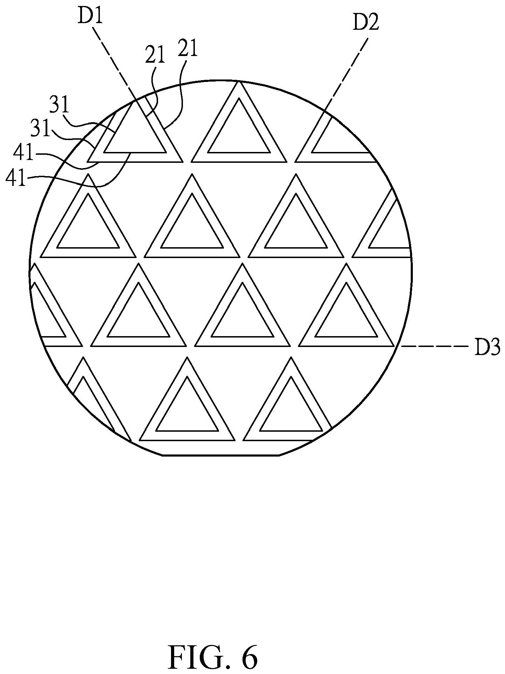

Next, please refer to FIG. 3 to FIG. 6 for the description of multiple embodiments of the silicon substrate structure 1000 of the present invention. As shown in FIG. 3, the first groove bodies 21 formed on the second surface 12 of the substrate 1 are parallel and arranged along the first direction D1. The second groove bodies 31 formed on the second surface 12 of the substrate 1 are parallel and arranged along the second direction D2. The third groove bodies 41 formed on the second surface 12 of the substrate 1 are parallel and arranged along the third direction D3. The first groove bodies 21, the second groove bodies 31, or the third groove bodies 41 are continuous groove bodies and extend to the outer peripheral portion 13 and the cutting edge portion 14 of the substrate 1. The first groove bodies 21, the second groove bodies 31 and the third groove bodies 41 present a triangular pattern connected to each other. In another embodiment of the present invention, similarly, the first groove bodies 21, the second groove bodies 31, and the third groove bodies 41 are respectively arranged along the first direction D1, the second direction D2, and the third direction D3 on the substrate 1. The first groove bodies 21, the second groove bodies 31 or the third groove bodies 41 are discontinuous and segmented groove bodies, only disposed on the outer periphery of the second surface 12 of the substrate 1. These groove bodies are not formed in the central portion of the substrate 1, as shown in FIG. 4. Furthermore, in another embodiment of the present invention, the first groove bodies 21, the second groove bodies 31 or the third groove bodies 41 are also discontinuous and segmented groove bodies. The first groove bodies 21, the second groove bodies 31, and the third groove bodies 41 are uniformly arranged on the substrate 1 along the first direction D1, the second direction D2, and the third direction D3 respectively. This arrangement results in the first groove bodies 21, the second groove bodies 31, and the third groove bodies 41 forming individual triangular patterns that are not interconnected, as shown in FIG. 5. Alternatively, in another embodiment of the present invention, the first groove bodies 21, the second groove bodies 31, or the third groove bodies 41 are also discontinuous and segmented groove bodies. The segmented first groove bodies 21, second groove bodies 31, and third groove bodies 41 are interconnected to form closed triangular patterns, and triangular patterns of different sizes can overlap with each other, as shown in FIG. 6. It should be noted that the first groove bodies 21, second groove bodies 31, and third groove bodies 41 of the silicon substrate structure 1000 of the present invention are mainly designed based on the corresponding lattice directions. The first groove bodies 21 are formed along the first direction D1, the second groove bodies 31 are formed along the second direction D2, and the third groove bodies 41 are formed along the third direction D3. The groove bodies formed in these three specific directions can alleviate or eliminate the stress generated at the bottom of the substrate due to high-temperature warping, and the embodiments in FIG. 3 to FIG. 6 are used as examples. The positions and quantities of the groove bodies formed can be adjusted according to actual requirements, which is not limited thereto.

In this embodiment, the first groove bodies 21, second groove bodies 31, and third groove bodies 41 can be formed through etching, laser cutting, and scraping methods. The manufacturing methods for these groove bodies are not limited thereto. Additionally, the densities of the first groove bodies 21, second groove bodies 31, and third groove bodies 41 located on the substrate 1 can be allocated based on the local stress ratios of the substrate 1. For instance, the distribution of the groove bodies can form comprehensive or partial patterns on the second surface 12 of the substrate 1. These patterns can also overlap or intersect in different sizes, and the groove bodies can also be adjusted in size for alternate use and other variations.

In summary, the silicone substrate structure of the present invention comprises a combination of a substrate, a first groove, a second groove, and a third groove. These grooves are formed along respective corresponding lattice directions. By designing a plurality of the first groove bodies in the first groove, a plurality of the second groove bodies in the second groove, and a plurality of the third groove bodies in the third groove, along with a length combination of groove body widths and the remaining thickness obtained by subtracting the groove depth from the substrate, the silicon substrate structure achieves a compressive space for strain release. Consequently, this design effectively reduces the occurrence of cracks during epitaxial growth and enhances epitaxial uniformity and production yield.

It will be apparent to those skilled in the art that various modifications and variations can be made to the structure of the present invention without departing from the scope or spirit of the invention. In view of the foregoing, it is intended that the present invention cover modifications and variations of this invention provided they fall within the scope of the following claims.

## Claims

1. A silicon substrate structure, comprising:
a substrate including a first surface and a second surface, wherein the first surface is formed on one side of the Si(111) lattice plane, and the second surface is formed on the opposite side of the Si(111) lattice plane;
a first groove being disposed along a first direction on the second surface;
a second groove being disposed along a second direction on the second surface; and
a third groove being disposed along a third direction on the second surface;
wherein the first direction is defined as a direction from the Si(111) lattice plane to the Si(1-1-1) lattice plane, the second direction is defined as a direction from the Si(-1 1-1) lattice plane to the Si(1-11) lattice plane, and the third direction is defined as an axial direction of the Si[1-10] lattice orientation.

2. The silicon substrate structure of claim 1, wherein a first included angle is formed between the first direction and a fourth direction of the Si(111) lattice plane, and a second included angle is formed between the second direction and the fourth direction of the Si(111) lattice plane, and wherein the third direction is perpendicular to the fourth direction, and the first included angle is substantially equal to the second included angle.

3. The silicon substrate structure of claim 2, wherein the first included angle and the second included angle are 35.26 ± 3 degrees.

4. The silicon substrate structure of any of the previous claims, wherein the first groove comprises a plurality of first groove bodies aligned parallel to the first direction and arranged side by side, the second groove comprises a plurality of second groove bodies aligned parallel to the second direction and arranged side by side, and the third groove comprises a plurality of third groove bodies aligned parallel to the third direction and arranged side by side.

5. The silicon substrate structure of claim 4, wherein the first groove bodies, the second groove bodies, or the third groove bodies are arranged in a continuous or segmented manner.

6. The silicon substrate structure of claim 4, wherein the first groove body has a first width, the second groove body has a second width, and the third groove body has a third width, wherein the first width, the second width, and the third width are equal.

7. The silicon substrate structure of claim 6, wherein each of the first width, the second width, and the third width ranges between 10 micrometers and 5 millimeters.

8. The silicon substrate structure of claim 4, wherein the substrate and the first groove body define a first height, the substrate and the second groove body define a second height, and the substrate and the third groove body define a third height, wherein the first height, the second height, and the third height are equal.

9. The silicon substrate structure of claim 8, wherein each of the first height, the second height, and the third height ranges between 500 micrometers and 2000 micrometers.

10. The silicon substrate structure of any of the previous claims, wherein the substrate has an outer peripheral portion and a cutting edge portion, and the outer peripheral portion is connected to the cutting edge portion to define the substrate as a non-circular substrate.
